# EUROPEAN PATENT SPECIFICATION

(11) **EP 1 440 607 B1**
(45) Date of publication and mention of the grant of the patent: **05.03.2008**
(21) Application number: 02783914.1
(22) Date of filing: 04.11.2002
(51) Int. Cl.: H05K 3/00, H04B 10/00, G01N 21/17

(54) **CARRIER ARRANGEMENT FOR CARRYING OPTICAL COMPONENTS AND CONNECTING OPTICAL SIGNALS AND METHOD OF MANUFACTURING THE SAME**
TRÄGERANORDNUNG FÜR OPTISCHE KOMPONENTEN UND ZUM VERBINDEN OPTISCHER SIGNALE UND VERFAHREN ZU DEREN HERSTELLUNG
DISPOSITIF SUPPORT SERVANT DE SUPPORT A DES COMPOSANTS OPTIQUES ET DE MOYEN DE COMMUTATION A DES SIGNAUX OPTIQUES ET PROCEDE DE FABRICATION DE CE DISPOSITIF

(30) Priority: 02.11.2001 SE 0103680; 02.11.2001 US 330880 P
(43) Date of publication of application: 28.07.2004
(73) Proprietor: IMEGO AB, 411 33 Göteborg (SE)
(72) Inventor: BERGSTEDT, Leif, S-518 40 Sjömarken (SE); LÖFVING, Björn, S-413 18 Göteborg (SE)
(74) Representative: Inger, Lars Ulf Bosson
(86) International application number: PCT/SE2002/002008
(87) International publication number: WO 2003/039216

(56) References cited:
- EP-A1- 0 405 482
- EP-A2- 0 986 197
- GB-A- 2 275 576
- US-A- 4 268 113

## Description

### TECHNICAL AREA

The invention refers to a carrier arrangement, in particular for carrying optical components and connecting optical signals, said carrier arrangement comprising a substrate having at least one hole. The hole is provided with an optically conducting filling for connecting said optical signals, The invention also relates to a manufacturing process thereof.

### DESCRIPTION OF STATE OF THE ART

A circuit board and specially a multilayer circuit board (PCB) includes vias, for example for insertion of component terminals, but mainly for connecting conductive paths on one layer to another layer.

Prior art discloses technology, which comprises via-holes filled with an electrically conductive paste.

US 6,159,767 relates to multi-chip and single-chip modules. A dielectric material is disposed on the upper surfaces of the chips and includes via-holes to at least some contact pads of the chips. The modules comprise a metallization layer on the dielectric layer as well. Circuitry having covered glass is shown, but said glass does not replace the conducting paste in the via-holes.

US 5,767,575 relates to electrical conductors such as micro-filled vias for electrically coupling, for instance a chip bonding pad. The micro-filled via are devoid of plated material, typically present in a conventional plated via. Further, the document describes a "micro filled via" material including a binding material and a number of particles dispersed in the binding material. The binding material can be any material such as a polymer being either conductive or non-conductive. The particles can be formed of a conductive material such as a conductive polymer or a conductive metal.

US 5,239,448 relates to a method of reducing the area of MCMs (Multi Chip Modules) being integrally attached to flexible carriers. The vias are filled with a conductive material by means of e.g. electro-deposition or plating.

However, transparent materials are known to be used for analyzing molecular samples, i.e. for detecting bio-molecular samples of biological fluids or material, etc. In US 5,936,730, a bio-molecule analyzer is shown including a plurality of test sites in a photo-conducting layer arranged onto a transparent substrate.

In Shuenemann et al, "A highly flexible design and production framework for mechanical micro-electrical systems" published in the technical paper "Sensor and Actuators" No. 93 (1999), p. 153-168, discloses a top-bottom ball grid array comprising a ball grid structure on its lower side and a land grid structure its the upper side, which is a packaged circuitry in a LTCC (Low Temperature Cofired Ceramic) structure showing micro-optical vias, however, the package do not constitute a substrate arranged in layers and the holes are not via-holes and through-holes, consequently a light is not conducted through said circuitry.

It is the object of European Patent Application No. 986297 (A2) to provide an optical transmitting/receiving method in which optical parts and electronic parts are mixed in the mounting structure on the same substrate to enable mounting such optical parts and electronic parts in the higher density and efficiency. A couple of plane type optical emitting/receiving elements are face-down mounted by the flip chip joining method on the upper surface of the multilayer substrate and the through-holes are respectively formed at the area just under the center of plane type optical emitting/receiving elements. At the internal wall of through-holes, the clad layer consisting of conductive layer where the plating process is conducted at the surface thereof is formed and the core layer consisting of the polymer resin is also formed at the center. At the lower surface of multilayer substrate, the optical waveguide extending linearly up to the area just under the other through-hole from the area just under one through-hole is formed. Moreover, the 45 DEG micro-mirrors are respectively formed at both end faces of the optical waveguide.

According to GB 2 275 576, an electronic circuit assembly consists of a printed circuit board having electronic components mounted on opposite faces of the board. The board has optically transmissive vias extending between the opposite faces of the board. The components on the two sides of the board communicate with each other by optical signals transmitted by transmission/reception means through the vias. The vias may be formed by excimer laser ablation, using a mask. The vias are not filled with any additional conductive material than air.

In US 4,268,113 a solid state optical transducer is mounted on a ceramic substrate, an optical signal path is provided by adding a preformed hole in form of a metal pin to the substrate in alignment with the active region of the transducer. The metal pin is provided with a light transmitting core consisting of an optical fiber and is inserted into the preformed hole using the same pin insertion techniques used to secure other solid pins to the substrate. The fiber is fixed by means of an adhesive agent.

EP 0 405 482 concerns an interconnection board for connecting electronic, electro-optical and/or optical devices and methods of manufacturing such boards. The interconnections are formed by scribing electrically or optically conductive filaments to form a signal conductor layer. The interconnection board comprises a base as a support member, an signal conductor layer laminated to the base and a surface conductor layer laminated to the signal conductor layer. The interlayer connections between the signal conductor layer and the surface conductor layer are formed by segments of the conductive filaments of the signal conductor layer displaced from the signal conductor layer to the vicinity of surface of the interconnection board to form part of or connect with the surface conductive pattern.

EP-A-0986197 discloses a multilayer substrate that carries optical components and connects optical signals. The substrate comprises through holes provided with an optically guiding filling.

### BRIEF DESCRIPTION OF THE INVENTION

The object of the invention is to provide an arrangement for supporting and carrying, for example for separate and selective detection of an optical signal by means of a detector. Thus, the main object of the invention is to provide a carrier arrangement, mainly consisting of a ceramic material, such as LTCC (Low Temperature Cofired Ceramic) or HTCC (High Temperature Cofired Ceramic), having vias for conducting light in via-direction of the carrier, and thereby enabling optical signaling, e.g. for telecommunications.

For these reasons, in the initially mentioned carrier arrangement, the optically filling comprises at least two different light guiding layers in the longitudinal direction of said hole. According to a preferred embodiment, the substrate at least partly consists of a ceramic material.

Preferably, the substrate at least partly consists of a glass composite material such as a LTCC (Low Temperature Cofired Ceramic) or a HTCC (High Temperature Cofired Ceramic) material provided with at least one conductive layer. The substrate at least partly may consists of a dielectric material.

The hole s provided as a cavity, a through-hole or a via. The hole can be arranged between two adjacent substrates. At least a part of a surface of the hole can be metallized through plating. Preferably, the metallization is performed by means of electrochemical plating, chemical plating, or metallized by means of immersion in a metal liquid, thermal spraying, electro-deposition, PVC (Physical Vapour Deposition) or CVD (Chemical Vapour Deposition).

In one embodiment, the optically conductive filling consists of an organic and/or inorganic non-metallic material. The optically conductive filling may consists of a ceramic material, a transparent composite material, such as a glass, a glass ceramic material, a composite material such as a fiber composite material, a plastic composite material, a polymer or the like. The optically conductive filling can be provided in powder form before transformation to a said layers.

The carrier arrangement can be provided with components on at least one side of the substrate. The components can be one or several one of MEMS (Micro Electro Mechanical System) or MCMs (Multi Chip Modules). Preferably, one or several of said components comprise an optical sensor.

The invention also relates to a method of manufacturing a carrier arrangement as defined in claim 15. The method may further comprise applying an additional surface treatment to at least one surface of the hole. The method may further comprise metallizing the surface of the hole.

According to a preferred embodiment, the method further comprises producing said hole using a laser whereby the surface of the hole obtains a smooth surface. The substrate consists of a ceramic material having conductor layers in between, and a dielectric material is provided in at least one layer on one surface of the substrate. The method further comprises initially providing the layers of the substrate with said holes, whereupon said layers are jointly provided on top of each other. The optically conductive filling is arranged by initially applying a first optically conductive substance peripherally in the hole, and subsequently applying a second optically conductive substance as an inner core material in the hole. Preferably, peripherally first optically conductive substance and the second optically conductive core substance have two different refractive indexes. Preferably, at least one optically conductive material has a gradually changing refractive index arranged in the hole. The gradually changing refractive index occurs between the first optically conductive substance and the second optically conductive substance arranged as a core.

The invention also relates to an analyzing device comprising a carrier arrangement. The device further comprises means for illuminating said hole provided with a sample and a detector for detecting illumination passing through said hole.

### BRIEF DESCRIPTION OF THE DRAWINGS

In the following, the invention will be described with reference to the embodiments according to enclosed drawings, in which:
- Fig. 1: is a cross-sectional view of a first embodiment of a carrier arrangement according to the invention,
- Fig. 2: is a cross-section through the encircled section in Fig. 1, illustrating the encircled part in more detail according to a second embodiment of the via filled with an optically conductive material, and
- Fig. 3: is a section of the side-view in Fig. 2, and
- Fig. 4: is a cross-section through an encircled section in Fig. 1, illustrating the encircled part in more detail according to a third embodiment of the invention.

### DESCRIPTION OF PREFERRED EMBODIMENTS

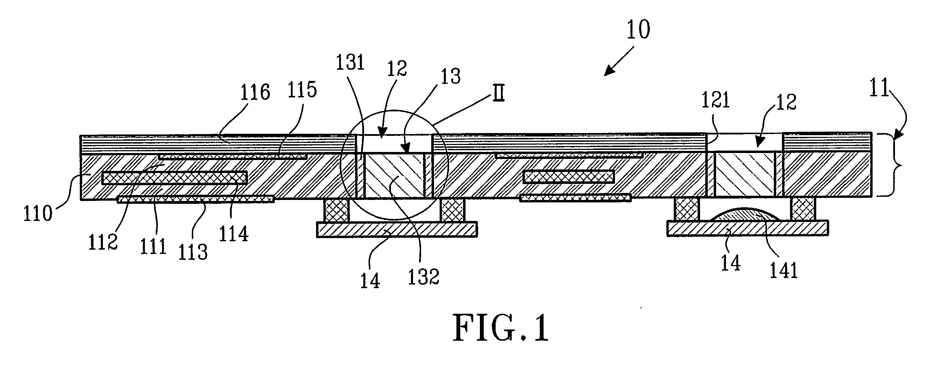

The carrier arrangement 10, according to the invention, which is schematically shown in Fig. 1, mainly consists of a substrate 11, one or several cavities or vias 12 filled with optically conductive filling comprising at least two materials 131 and 132. An optically conductive material is preferably a transparent material for the wavelength used. On at least one side of the carrier, e.g. electro-optical components 14, i.e. optical detectors for converting optical signals to electrical signals, are arranged. The components may comprise active and/or passive components, such as resistors, capacitors, etc.

According to a preferred embodiment, the substrate 11 is made of a ceramic material, for instance a glass composite material, such as LTCC (Low Temperature Cofired Ceramic) 110 or HTCC (High Temperature Cofired Ceramic). The LTCC material may for instance be provided in several layers 111 and 112, arranged with electrically conductive layers 113, 114 and 115, such as copper conductors, in between. On one surface, the substrate 11 is provided with a dielectric material, such as a BCB (Benzocyklobutan) material 116 in one or several layers. Optionally, the dialectic layer can be excluded. The opening formed in exposed areas in the dielectric layer builds a crater, which can be used for analyzing samples. In this case the substances are provided into the crater, illuminated and a detector at the opposite side can be used to detect the illumination through the via. Thus, the invention can be used as a part of an analyzing device. However, the invention is not limited to this.

The substrate 11 is provided with one or several through-holes forming cavities or vias 12. A cavity can be provided as a part of a through-hole, a via 12 or the like. The substrate 11 can also be provided with components, as described in detail below. However, in one embodiment of the invention, a component can be provided completely or partly inside the substrate 11, i.e. substantially embedded in the substrate 11. Consequently, the cavity can extend between at least two layers. Furthermore, a through-hole can also be arranged between two or several adjacent substrates 11.

In the most preferred embodiment, as illustrated in Figs. 1, 2 and 3, the optically conductive material is arranged by initially applying a first optically conductive material 131 peripherally in the via 12, and subsequently applying a second optically conductive material 132 as a core. Consequently, the peripherally first optically conductive material 131 and the second optically conductive core material 132 obtain two different refractive indexes n1 and n2. Thus, the two optically conductive materials 131 and 132 are clearly arranged divided in two layers having a clearly defined intermediate boundary layer. The radial refractive index profile in a cross section of the via can have arbitrary shape.

It is also possible, that one of the optically conductive materials 131 or 132 can have a gradually transitory refractive index during the manufacturing step. Thus, the gradually changing refractive index occurs between the first optically conductive substance 131, and the second optically conductive substance 132 arranged as the core.

The optically conductive materials 131 and 132 may consist of an organic material such as harts or inorganic non-metallic material, such as a ceramic material, a transparent composite material such as a glass, a glass ceramic material, a fiber composite material, a plastic composite material, a polymer or the like. In fact, the optically conductive filling 13 be a wavelength-adapted material, adapted to optically guide or transmit an optical signal such as a light signal or an illumination of a specific wavelength. However, the optically conductive filling 13 is preferably arranged to be transparent as mentioned above.

The components 14 are arranged in communication with one or several vias in one or both sides of the substrate. In a preferred embodiment, a component 14 such as a detector is mounted adjacent to the via 12, for instance in front of the via 11 on one side of the substrate 11, e.g. substantially centered with respect to said via 12.

Preferably, the holes can have varying sizes and forms. Moreover, as a result of the manufacturing process, the inner surface 121 of the via 12 obtains particular surface characteristics such as a surface roughness or surface smoothness.

The surface 121 of the via 12 can be arranged with a surface roughness of e.g. 0.1 - 600 µm, whereupon the via 12 is applied with the first optically transparent material 131, preferably without providing said inner surface 121 of the via 12 with an additional surface treatment or coarse finishing.

Yet, in another embodiment of the invention, wherein the via 12 is made by using laser, it can obtain a smooth and polished inner surface 121.

Preferably, the optically conductive material is deposited in a pulverous form to be heated and then melted. The pulverous material applied in the via 12 is heated, whereby the organic matter of it is melted and the optical conductor 13 is formed in the via 12 taking the shape of the hole, forming a cylinder, a glass plug, a glass rod or the like. Thus, the obtained optically conductor 13 is preferably transparent.

The components 14 can be any of: sensors or detectors preferably mounted in so called flip-chip technology, e.g. MCMs (Multi Chip Modules) and MEMS (Micro Electro Mechanical Systems). Some of said components can also comprise illuminators, such as for light, LASER or some the like.

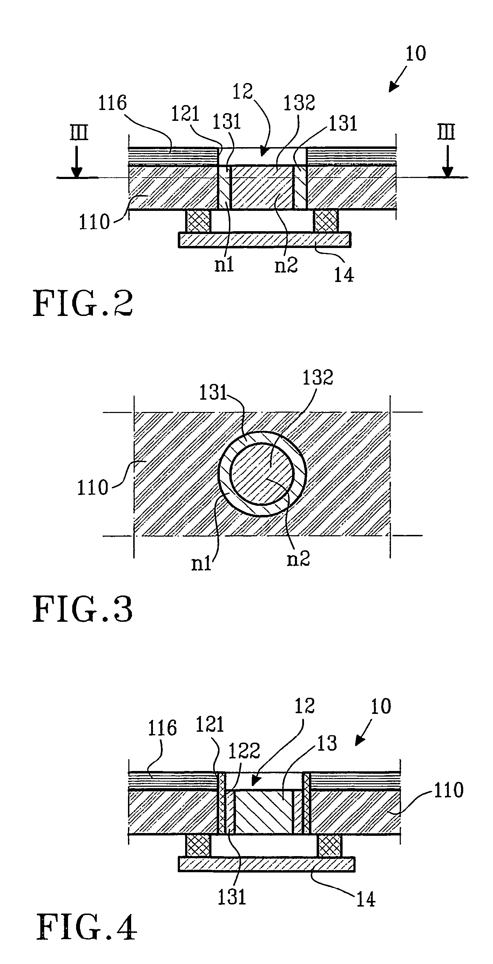

In another preferred embodiment of the invention, according to Fig. 4, the surface 121 of the via 12 is provided with a metallic layer 122, whereupon the via 12 is arranged with the optically transparent layers 13 and 131. In this case, a suitable metallization method is plating, e.g. electrochemical or chemical plating. Other metallization methods involve for instance immersion in a metal liquid, thermal spraying, electro-deposition, PVC (Physical Vapour Deposition) or CVD (Chemical Vapour Deposition).

The optical vias, according to the invention, can be used in any application where a light signal must be transmitted through a carrier, e.g. in communication devices and more specifically telecommunication devices.

The invention is not limited to the shown embodiments but can be varied in a number of ways, e.g. through combination of two or more embodiments shown, without departing from the scope of the appended claims and the arrangement and the method can be implemented in various ways depending on application, functional units, needs and requirements etc.

## Claims

1. A carrier arrangement (10), in particular for carrying optical components and connecting optical signals, said carrier arrangement comprising a substrate (11) having at least one hole (12), said hole being provided with an optically guiding filling (13) for connecting said optical signals,
**characterized in**
**that** said optically guiding filling (13) comprises at least two different light guiding layers (131, 132) in the longitudinal direction of said hole.

2. An arrangement as claimed in claim 1,
***characterised in***
**that** said substrate (11) at least partly consists of a ceramic material.

3. An arrangement as claimed in claims 1 and 2,
***characterised in***
**that** the substrate (11) at least partly consists of a glass composite material such as a LTCC (Low Temperature Cofired Ceramic) (110) or a HTCC (High Temperature Cofired Ceramic) material provided with at least one conductive layer (113, 114, 115).

4. An arrangement as claimed in claims 1 - 3,
***characterised in***
**that** said substrate (11) at least partly consists of a dielectric material (116).

5. An arrangement as claimed in claim 1,
***characterised in***
**that** the hole (12) is provided as a cavity, a through-hole or a via.

6. An arrangement as claimed in claims 1 and 4,
***characterised in***
**that** the hole (12) is arranged between two adjacent substrates (11).

7. An arrangement as claimed in claims 1 and 5 - 6,
***characterised in,***
**that** at least a part of a surface (121) of the hole (12) is plated.

8. An arrangement as claimed in claim 7,
***characterised in***
**that** said plating is performed by means of electrochemical plating, chemical plating, or metallization by means of immersion in a metal liquid, thermal spraying, electro-deposition, PVC (Physical Vapour Deposition) or CVD (Chemical Vapour Deposition).

9. An arrangement as claimed in claim 1,
***characterised in***
**that** said at least one optically guiding filling (13) consists of an organic and/or inorganic non-metallic material.

10. An arrangement as claimed in claim 9,
***characterised in***
**that** the at least one optically guiding filling (13) consists of a ceramic material, a guiding composite material, such as a glass, a glass ceramic material, a composite material such as a fibre composite material, a plastic composite material, a polymer or the like.

11. An arrangement as claimed in claim 9 - 10,
***characterised in***
**that** the at least one optically guiding filling (13) is provided in powder form before transformation to a said layers.

12. An arrangement as claimed in claim 1,
***characterised in,***
**that** the carrier arrangement (10) is provided with components (14) on at least one side of the substrate (11).

13. An arrangement as claimed in claim 12,
***characterised in,***
**that** said components (15) are one of MEMS (Micro Electro Mechanical System) or MCMs (Multi Chip Modules).

14. An arrangement as claimed in claims 12 or 13,
***characterized in***
**that** one or several of said components (14) comprise an optical sensor (141).

15. A method of manufacturing a carrier arrangement (10) according to claim 1, in particular for carrying optical components and connecting optical signals, the arrangement comprising at least one substrate (11), wherein the method comprises the steps of:
- providing a hole (12) in said substrate (11),
- applying a first optically guiding filling (13) in said at least one hole (12) in powder form and melting said powder Into a solid form in a first step, and
- applying a second optically guiding filling in said at least one hole (12) in powder form and melting said powder into a solid form in a second step.

16. A method as claimed in claim 15,
***characterized by***
applying an additional surface treatment to at least one surface (121) of the hole (12).

17. A method as claimed in claim 15,
***characterised by***
metallizing the surface (121) of the hole (12).

18. A method as claimed in claim 15, producing said hole (12) using a laser whereby the surface (121) of the hole (12) obtains a smooth surface.

19. A method as claimed in claim 15,
***characterised in***
**that** the substrate (11) consists of a ceramic material having conductor layers (113, 114, 115) in between, and a dielectric material (116) is provided in at least one layer on one surface of the substrate (11).

20. A method as claimed in claim 15,
***characterised by***
initially providing the layers of the substrate (11) with said holes (12), whereupon said layers are jointly provided on top of each other.

21. A method as claimed in claim 15,
***characterised in***
**that** the optically guiding filling (13) is arranged by initially applying a first optically guiding substance (131) peripherally in the hole (12), and subsequently applying a second optically guiding substance (132) as an inner core material in the hole (12).

22. A method as claimed in claim 21,
***characterised in***
**that** said peripherally first optically guiding substance (131) and the second optically guiding core substance (132) have two different refractive indexes (n1, n2).

23. A method as claimed in claim 21,
***characterised in***
**that** said at least one optically guiding material (13) has a gradually changing refractive index arranged in the hole (12).

24. A method as claimed in claim 23,
***characterised in***
**that** the gradually changing refractive index occurs between the first optically guiding substance (131) and the second optically guiding substance arranged (132) as a core.

25. An analyzing device comprising a carrier arrangement (10) according to any one of claims 1 to 14.

26. The device according to claim 25,
**characterized in**
**that** said device further comprises means for illuminating said hole provided with a sample and a detector for detecting illumination passing through said hole.

## Patentansprüche

1. Trägeranordnung (10), insbesondere zum Tragen von optischen Komponenten und zur Verbindung von optischen Signalen, wobei die Trägeranordnung ein Substrat (11) umfasst, welches mindestens ein Loch (12) aufweist, wobei das Loch mit einer optisch leitenden Füllung (13) versehen ist, um die optischen Signale zu verbinden,
**dadurch gekennzeichnet,**
**dass** die optisch leitende Füllung (13) mindestens zwei verschiedene Licht leitende Schichten (131, 132) in der Längsrichtung des Lochs umfasst.

2. Anordnung nach Anspruch 1,
**dadurch gekennzeichnet,**
**dass** das Substrat (11) zumindest teilweise aus einem Keramikmaterial besteht.

3. Anordnung nach Anspruch 1 und 2,
**dadurch gekennzeichnet,**
**dass** das Substrat (11) zumindest teilweise aus einem Glasverbundstoff, wie z.B. einem LTCC- (Niedertemperatur-Einbrand-Keramik-) (110) oder einem HTCC-(Hochtemperatur-Einbrand-Keramik-) Material, welches mit mindestens einer leitfähigen Schicht (113, 114, 115) versehen ist, besteht.

4. Anordnung nach Ansprüchen 1 - 3,
**dadurch gekennzeichnet,**
**dass** das Substrat (11) zumindest teilweise aus einem dielektrischen Material (116) besteht.

5. Anordnung nach Anspruch 1,
**dadurch gekennzeichnet,**
**dass** das Loch (12) als eine Aushöhlung, ein Durchgangsloch oder ein Via vorhanden ist.

6. Anordnung nach Anspruch 1 und 4,
**dadurch gekennzeichnet,**
**dass** das Loch (12) zwischen zwei benachbarten Substraten (11) angeordnet ist.

7. Anordnung nach Ansprüchen 1 und 5 - 6,
**dadurch gekennzeichnet,**
**dass** mindestens ein Teil einer Fläche (121) des Loches (12) beschichtet ist.

8. Anordnung nach Anspruch 7,
**dadurch gekennzeichnet,**
**dass** das Beschichten mittels eines elektrochemischen Beschichtens, eines chemischen Beschichtens oder einer Metallisierung mittels einer Immersion in einer metallischen Flüssigkeit, eines thermischen Besprühens, einer elektrolytischen Abscheidung, einer PVD (physikalischen Gasphasenabscheidung) oder einer CVD (chemischen Gasphasenabscheidung) ausgeführt wird

9. Anordnung nach Anspruch 1,
**dadurch gekennzeichnet,**
**dass** die mindestens eine optisch leitende Füllung (13) aus einem organischen und/oder anorganischen nicht metallischen Material besteht.

10. Anordnung nach Anspruch 9,
**dadurch gekennzeichnet,**
**dass** die mindestens eine optisch leitende Füllung (13) aus einem Keramikmaterial, einem leitenden Verbundstoff, wie z.B. einem Glas, einem Glaskeramikmaterial, einem Verbundmaterial, wie z.B. einem Faserverbundmaterial, einem Kunststoffverbundmaterial, einem Polymer oder dergleichen besteht.

11. Anordnung nach Anspruch 9 - 10,
**dadurch gekennzeichnet,**
**dass** die mindestens eine optisch leitende Füllung (13) in einer Pulverform vor einer Übertragung auf die Schichten bereitgestellt ist.

12. Anordnung nach Anspruch 1,
**dadurch gekennzeichnet,**
**dass** die Trägeranordnung (10) mit Komponenten (14) auf mindestens einer Seite des Substrats (11) versehen ist.

13. Anordnung nach Anspruch 12,
**dadurch gekennzeichnet,**
**dass** die Komponenten (15) ein MEMS (mikroelektromechanisches System) oder MCMs (Multi-Chip-Module) sind.

14. Anordnung nach Anspruch 12 oder 13,
**dadurch gekennzeichnet,**
**dass** eine oder mehrere der Komponenten (14) einen optischen Sensor (141) umfassen.

15. Verfahren zur Herstellung einer Trägeranordnung (10) nach Anspruch 1, insbesondere zum Tragen von optischen Komponenten und zur Verbindung von optischen Signalen, wobei die Anordnung zumindest ein Substrat (11) umfasst, wobei das Verfahren die Schritte umfasst:
- Bereitstellen eines Lochs (12) in dem Substrat (11),
- Aufbringen einer ersten optisch leitenden Füllung (13) in Pulverform in das mindestens eine Loch (12) und Schmelzen des Pulvers in eine feste Form in einem ersten Schritt, und
- Aufbringen einer zweiten optisch leitenden Füllung (13) in Pulverform in das mindestens eine Loch (12) und Schmelzen des Pulvers in eine feste Form in einem zweiten Schritt.

16. Verfahren nach Anspruch 15,
**gekennzeichnet durch**
ein Durchführen einer zusätzlichen Oberflächenbehandlung auf mindestens einer Fläche (121) des Lochs (12).

17. Verfahren nach Anspruch 15,
**gekennzeichnet durch**
ein Metallisieren der Fläche (121) des Lochs (12).

18. Verfahren nach Anspruch 15, wobei das Loch (12) unter Verwendung eines Lasers hergestellt wird, wodurch die Fläche (121) des Lochs (12) eine glatte Oberfläche erhält.

19. Verfahren nach Anspruch 15,
**dadurch gekennzeichnet,**
**dass** das Substrat (11) aus einem Keramikmaterial mit Leiterschichten (113, 114, 115) dazwischen besteht, und dass ein dielektrisches Material (116) in mindestens einer Schicht auf einer Fläche des Substrats (11) vorhanden ist

20. Verfahren nach Anspruch 15,
**gekennzeichnet durch**
ein anfängliches Bereitstellen der Schichten des Substrats (11) mit Löchern (12), worauf die Schichten gemeinsam jeweils aufeinander bereitgestellt werden.

21. Verfahren nach Anspruch 15,
**dadurch gekennzeichnet,**
**dass** die optisch leitende Füllung (13) angeordnet wird, indem anfangs eine erste optisch leitende Substanz (131) am Umfang in das Loch (12) aufgebracht wird, und indem nachfolgend eine zweite optisch leitende Substanz (132) als ein inneres Kernmaterial in das Loch (12) aufgebracht wird.

22. Verfahren nach Anspruch 21,
**dadurch gekennzeichnet,**
**dass** die erste optisch leitende Substanz (131) am Umfang und die zweite optisch leitende Kernsubstanz (132) zwei unterschiedliche Brechungsindizes (n1, n2) aufweisen.

23. Verfahren nach Anspruch 21,
**dadurch gekennzeichnet,**
**dass** das mindestens eine optisch leitende Material (13) in dem Loch (12) ein sich allmählich ändernden Brechungsindex aufweist.

24. Verfahren nach Anspruch 23,
**dadurch gekennzeichnet,**
**dass** der sich allmählich ändernde Brechungsindex zwischen der ersten optisch leitenden Substanz (131) und der zweiten optisch leitenden Substanz (132), welche als ein Kern angeordnet ist, auftritt.

25. Analysevorrichtung umfassend eine Trägeranordnung (10) nach einem der Ansprüche 1 bis 14.

26. Vorrichtung nach Anspruch 25,
**dadurch gekennzeichnet,**
**dass** die Vorrichtung weiter Mittel zur Beleuchtung des Loches umfasst, welche mit einem Prüfobjekt und einem Detektor versehen sind, um eine durch das Loch verlaufende Beleuchtung zu erfassen.

## Revendications

1. Agencement de support (10), en particulier pour supporter des composants optiques et connecter des signaux optiques, ledit agencement de support comportant un substrat (11) ayant un moins un trou (12), ledit trou étant muni d'une garniture de guidage optique (13) pour connecter lesdits signaux optiques,
**caractérisé en ce que**
ladite garniture de guidage optique (13) comporte au moins deux couches de guidage de lumière différentes (131, 132) dans la direction longitudinale dudit trou.

2. Agencement selon la revendication 1,
**caractérisé en ce que**
ledit substrat (11) est constitué au moins partiellement d'un matériau céramique.

3. Agencement selon les revendications 1 et 2,
**caractérisé en ce que**
le substrat (11) est constitué au moins partiellement d'un matériau composite de verre tel que LTCC (Céramique Co-cuite à Basse Température) (110) ou d'un matériau HTCC (Céramique Co-cuite à Haute Température) muni d'au moins une couche conductrice (113, 114, 115).

4. Agencement selon les revendications 1 à 3,
**caractérisé en ce que**
ledit substrat (11) est constitué au moins partiellement d'un matériau diélectrique (116).

5. Agencement selon la revendication 1,
**caractérisé en ce que**
le trou (12) est fourni sous forme d'une cavité, un trou traversant, ou d'une traversée.

6. Agencement selon les revendications 1 et 4,
**caractérisé en ce que**
le trou (12) est agencé entre deux substrats adjacents (11).

7. Agencement selon les revendications 1 et 5 et 6,
**caractérisé en ce que**
au moins une partie d'une surface (121) du trou (12) est plaquée.

8. Agencement selon la revendication 7,
**caractérisé en ce que**
ledit plaquage est effectué par l'intermédiaire d'un plaquage électrochimique, d'un plaquage chimique, ou d'une métallisation par l'intermédiaire d'une immersion dans un liquide métallique, d'une vaporisation thermique, d'un électro-dépôt, d'un PVC (Dépôt Physique en Phase Vapeur) ou d'un CVD (Dépôt Chimique en Phase Vapeur).

9. Agencement selon la revendication 1,
**caractérisé en ce que**
ladite au moins une garniture de guidage optique (13) est constituée d'un matériau non-métallique organique et/ou inorganique.

10. Agencement selon la revendication 9,
**caractérisé en ce que**
la au moins une garniture de guidage optique (13) est constituée d'un matériau céramique, d'un matériau composite de guidage, tel que du verre, d'un matériau céramique de verre, d'un matériau composite tel qu'un matériau composite fibreux, d'un matériau composite plastique, d'un polymère ou analogue.

11. Agencement selon les revendications 9 et 10,
**caractérisé en ce que**
au moins une garniture de guidage optique (13) est fournie sous une forme de poudre avant transformation en lesdites couches.

12. Agencement selon la revendication 1,
**caractérisé en ce que**
l'agencement de support (10) est muni de composants (14) sur au moins un côté du substrat (11).

13. Agencement selon la revendication 12,
**caractérisé en ce que**
lesdits composants (15) sont l'un parmi MEMS (Micro Système ElectroMécanique) ou MCM (Modules MultiPuces).

14. Agencement selon la revendication 12 ou la revendication 13,
**caractérisé en ce que**
un ou plusieurs desdits composants (14) comportent un capteur optique (141).

15. Procédé pour fabriquer un agencement de support (10) selon la revendication 1, en particulier pour supporter des composants optiques et connecter des signaux optiques, l'agencement comportant au moins un substrat (11), le procédé comportant les étapes consistant à :
- agencer un trou (12) dans ledit substrat (11),
- appliquer une première garniture de guidage optique (13) dans ledit au moins un trou (12) sous une forme de poudre et faire fondre ladite poudre en une forme solide lors d'une première étape, et
- appliquer une seconde garniture de guidage optique dans ledit au moins trou (12) sous une forme de poudre et faire fondre ladite poudre en une forme solide lors d'une seconde étape.

16. Procédé selon la revendication 15,
**caractérisé par**
l'application d'un traitement de surface supplémentaire à au moins une surface (121) du trou (12).

17. Procédé selon la revendication 15,
**caractérisé par**
la métallisation de la surface (121) du trou (12).

18. Procédé selon la revendication 15, produisant ledit trou (12) en utilisant un laser de sorte que la surface (121) du trou (12) devient une surface lisse.

19. Procédé selon la revendication 15,
**caractérisé en ce que**
le substrat (11) est constitué d'un matériau céramique ayant des couches conductrices (113, 114, 115) entre celui-ci, et un matériau diélectrique (116) est agencé dans au moins une couche sur une surface du substrat (11).

20. Procédé selon la revendication 15,
**caractérisé par**
l'agencement initial dans les couches du substrat (11) desdits trous (12), après quoi lesdites couches sont agencées conjointement les unes sur les autres.

21. Procédé selon la revendication 15,
**caractérisé en ce que**
la garniture de guidage optique (13) est agencée en appliquant initialement une première substance de guidage optique (131) à la périphérie du trou (12), et en appliquant par la suite une seconde substance de guidage optique (132) comme un matériau de coeur intérieur dans le trou (12).

22. Procédé selon la revendication 21,
**caractérisé en ce que**
ladite première substance de guidage optique périphérique (131) et la seconde substance de coeur de guidage optique (132) ont deux indices de réfraction différents (n1, n2).

23. Procédé selon la revendication 21,
**caractérisé en ce que**
ledit au moins un matériau de guidage optique (13) a un indice de réfraction changeant graduellement agencé dans le trou (12).

24. Procédé selon la revendication 23,
**caractérisé en ce que**
l'indice de réfraction changeant graduellement apparaît entre la première substance de guidage optique (131) et la seconde substance de guidage optique (132) agencée sous forme d'un coeur.

25. Dispositif d'analyse comportant un agencement de support (10) selon l'une quelconque des revendications 1 à 14.

26. Dispositif selon la revendication 25,
**caractérisé en ce que**
ledit dispositif comporte de plus des moyens pour illuminer ledit trou muni d'un échantillon et un détecteur pour détecter une illumination passant à travers ledit trou.
